# EUROPÄISCHE PATENTSCHRIFT

(11) **EP 2 384 374 B1**
(45) Veröffentlichungstag und Bekanntmachung des Hinweises auf die Patenterteilung: **26.03.2014**
(21) Anmeldenummer: 09779001.8
(22) Anmeldetag: 30.01.2009
(51) Int. Cl.: C23C 14/34, H01J 37/34

(54) **ROHRTARGET**
Tubular target
Cible tubulaire

(43) Veröffentlichungstag der Anmeldung: 09.11.2011
(73) Patentinhaber: Praxair S.T. Technology, Inc., North Haven, CT 06473 (US)
(72) Erfinder: WURCZINGER, Dieter, 61118 Bad Vilbel (DE)
(74) Vertreter: Patentanwälte Olbricht Buchhold Keulertz
(86) Internationale Anmeldenummer: PCT/EP2009/051102
(87) Internationale Veröffentlichungsnummer: WO 2010/086025

(56) Entgegenhaltungen:
- EP-A- 1 752 556
- WO-A-2006/063721
- DE-A1-102005 020 250
- DE-A1-102006 060 512

## Beschreibung

Diese Erfindung betrifft ein Rohrtarget nach dem Oberbegriff des Anspruchs 1.

Bei den meisten Sputter-Targets, die in der Vergangenheit verwendet wurden, handelt es sich um so genannte Planar-Targets, die kreisförmig oder rechteckig ausgebildet sein. Diese Planar-Targets haben jedoch den Nachteil, dass nur etwa 30% bis 40% des Materials, aus dem sie bestehen, effektiv gesputtert werden.

Um die Effektivität des Sputterns zu erhöhen, kommen immer mehr rohrförmige Targets zum Einsatz. Allerdings ist deren Herstellung schwieriger als das Herstellen von planaren Targets.

Es ist bereits ein Verfahren für die Herstellung eines Zerstäubungstargets bekannt, bei dem zuerst ein zylindrisches Trägerelement derart in eine Gussform eingeführt wird, dass ein Freiraum zwischen dem Trägerelement und der Gussform entsteht (EP 500 031 B1).

Hierauf wird ein Targetmaterial in diesen Freiraum zwischen dem Trägerelement und der Gussform eingefüllt und die Gussform geschlossen. Sodann wird eine isostatische Heißpressung auf das Targetmaterial und das Trägerelement aufgebracht. Durch das isostatische Pressen wird die Bondingkraft zwischen dem Targetmaterial und der äußeren Oberfläche des Trägerelements verbessert.

Weiterhin ist eine Rohrkathode für die Verwendung bei einem Sputterprozess bekannt, die einen Targetträger und ein Target aufweist, wobei sich zwischen Targetträger und Target eine elektrisch und thermisch gut leitende Schicht befindet (EP 1 752 556 A1). Die thermisch gut leitende Schicht ist hierbei entlang der Längsachse des Targetträgers in mehreren Einzelschichten unterteilt, die einen Abstand voneinander haben.

Eine Segmentierung eines Rohrtargets senkrecht zur Längsachse ist aus WO 2007/0414125 A2 bekannt. Dabei besitzt das zylindrische Target eine Länge von mehr als ungefähr sechsunddreißig inch (= ca. 91 cm) und weist einen oder mehrere zylindrische Sputtersektionen auf. Innerhalb des zylindrischen Targets ist eine Trägerröhre vorgesehen. Eine Befestigungsschicht aus Indium befindet sich zwischen dem zylindrischen Sputter-Target und der zylindrischen Trägerröhre, um das Target mit der Trägerröhre zu verbinden.

Weiterhin ist ein Rohrtarget mit einem zylindrischen Trägerrohr und mindestens einem an dessen Mantelfläche angeordneten Targetrohr bekannt (WO 2006/063721 A1). Hierbei ist zwischen dem Targetrohr und dem Trägerrohr eine Verbindungsschicht angeordnet, die leitfähig ist und einen Benetzungsgrad von > 90 % aufweist.

Ähnliche Rohrtargets sind aus folgenden Druckschriften bekannt: US 2001/0047936 A1; US 2001/0047936 A1; JP 4350161; JP 2006-083408.

Die bekannten Rohrkathoden werden während des Sputterprozesses stark erhitzt, so dass sie mittels Kühlwasser gekühlt werden müssen. Da die Anforderungen an die Leistungsdichten von Rohrkathoden immer höher werden, muss auch die Kühlung immer effizienter werden. Hierbei kommt es zu großen Temperaturdifferenzen zwischen der Innenwand und der Außenwand des Targetrohrs. Die Innenwand ruht nämlich auf der Außenwand eines Trägerrohrs, in dessen Innerem das Kühlwasser transportiert wird, während die Außenwand dem heißen Plasma ausgesetzt ist. Durch das Einwirken des Plasmas ergeben sich hohe Temperaturen, wodurch sich das Target ausdehnt. Da das Target durch die Innenkühlung gleichzeitig gekühlt wird, entsteht ein Temperaturgradient über die Dicke des Targets. Weil sich jedoch das Target aufgrund der hohen Temperaturen des Plasmas auch ausdehnt, treten radiale Abrisskräfte auf, die dazu führen, dass das Target beschädigt oder gar zerstört wird, womit eine gleichmäßige Beschichtung nicht mehr möglich ist.

Der Erfindung liegt deshalb die Aufgabe zugrunde, die Spannungen zwischen der Targetinnenseite und der Targetaußenseite abzubauen.

Diese Aufgabe wird gemäß den Merkmalen des Patentanspruchs 1 gelöst.

Die Erfindung betrifft ein Rohrtarget zum Sputtern mit einem auf einem zylindrischen Trägerrohr angeordneten Target. Dieses Target ist in mehrere Segmente unterteilt. Parallel oder schräg zu seiner Drehachse weist das Target wenigstens eine Nut auf.

Vorzugsweise weist das Rohrtarget ein zylindrisches Trägerrohr auf, auf dem ein zylindrisches Target angeordnet ist, welches in mindestens ein Segment unterteilt ist. Zwischen dem Target und den Trägerrohr ist ein Verbindungsstück vorgesehen. Parallel und/oder schräg zu seiner Drehachse weist das Target wenigstens eine Nut auf.

Der mit der Erfindung erzielte Vorteil besteht insbesondere darin, dass die Spannungen im Rohrtarget abgebaut werden. Dieser Spannungsabbau wird durch das Anbringen von zumindest einer Nut im Target erreicht. Durch diese Nut werden die radialen Abrisskräfte in tangentiale Kräfte umgewandelt. Durch diese tangentialen Kräfte wird die zumindest eine Nut verengt oder gar verschlossen. Ein Abreißen des Targets wird somit verhindert. Dieser Spannungsabbau ist insbesondere bei sprödem Target-Material vorteilhaft, z. B. bei Rohrtargets aus ITO, ZnO, ZnO:Al₂O₃, ZnO:Ga₂O₃, ZnO:In₂O₃ oder mit anderen Dotierungen bzw. SnO₂, SnO₂ mit Sb und anderen Dotierungen; und weiteren Oxiden und Suboxiden wie beispielsweise Nb₂Oₓ, Ta₂Oₓ, WOₓ, MoOₓ, TiₓNb_{y}O_{z}, TiOₓ, SiO₂, Al₂O₃, Si₃Oₓ, MgOₓ, Silizium, Verbindungen von Si und Al, Nitriden, z. B. TiN, ZrN, Si₃Nₓ, Karbiden wie z.B. SiC, WC, Siliziden, Boriden, Fluoriden, Seleniden, Sulfiden, Telluriden und Mischungen dieser Substanzen. Aber auch bei Targets aus Metallen und Metall-Legierungen sowie deren Verbindungen kann die Erfindung vorteilhaft eingesetzt werden.

Ausführungsbeispiele der Erfindung sind in den Zeichnungen dargestellt und werden im Folgenden näher beschrieben.

Es zeigen:
Fig. 1 eine perspektivische Ansicht eines Rohrtargets mit einer geraden Nut;
Fig. 2 eine perspektivische Ansicht eines Rohrtargets mit einer schrägen Nut;
Fig. 3 eine perspektivische Ansicht eines Rohrtargets mit einer geraden und einer schrägen Nut;
Fig. 4 eine perspektivische Ansicht eines Rohrtargets mit geraden und senkrecht hierzu verlaufenden Nuten;
Fig. 5 einen Querschnitt durch einen Ausschnitt eines Rohrtargets mit einer Nut vor einer Plasma-Hitzeeinwirkung;
Fig. 6 den Querschnitt nach Fig. 5 nach der Plasma-Hitzeeinwirkung;
Fig. 7 einen Querschnitt durch ein Target, das auf einem Targetträger angeordnet ist;
Fig. 8 einen Längsschnitt durch das Target gemäß der Fig. 7;
Fig. 9 einen Querschnitt durch ein Rohrtarget;
Fig. 10 einen Längsschnitt durch eine Variante eines Rohrtargets;
Fig. 11 eine perspektivische Ansicht eines Rohrtargets mit mehreren schrägen Nuten.

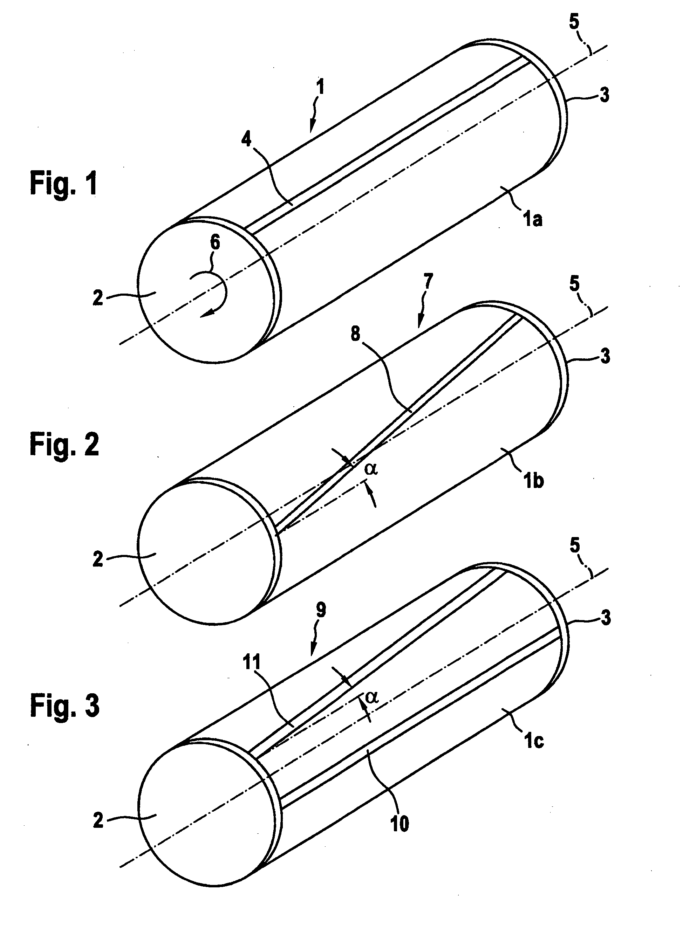

In der Fig. 1 ist ein Rohrtarget 1 in perspektivischer Ansicht und schematisch dargestellt. Der Einfachheit halber ist es hier mit Deckeln 2, 3 abgeschlossen. Dieses Rohrtarget 1 weist ein in der Fig. 1 nicht erkennbares Trägerrohr auf, das von einem Target 1 a umgeben ist. Dieses Target 1 a ist mit einer Nut 4 versehen, die parallel zu einer Drehachse 5 des Rohrtargets 1 verläuft. Mit einem Pfeil 6 ist die Drehrichtung angedeutet. Die Tiefe der Nut 4 ist nicht festgelegt.

Über oder unter einem Teil des Rohrtargets 1 befindet sich beim Sputtervorgang ein Plasma. Dieses Plasma ist im Wesentlichen ebenso lang wie das Rohrtarget 1, hat aber einen Durchmesser, der kleiner ist als der Durchmesser des Rohrtargets 1. Dreht sich das Rohrtarget 1, so liegt während des Unter- oder Überstreichens des Plasmas die Nut 4 mit ihrer gesamten Länge über oder unter dem Plasma. Das Eintauchen, Verweilen und Austreten der Nut 4 in das bzw. aus dem Plasma verändert die dem Plasma zugewandte Oberfläche des Targets 1 a und damit die Plasmaimpedanz. Hierdurch kann das Sputterverhalten stark beeinträchtigt werden. Es kann dabei zu Spannungs- und Stromänderungen kommen, die wiederum Überschläge (arcing) verursachen, welche die zu beschichtenden Substrate schädigen können.

Fig. 2 zeigt eine Variante des Rohrtargets nach Fig. 1, das ein Target 1 b aufweist. Das Target 1 b dieses Rohrtargets 7 weist eine Nut 8 auf, die nicht parallel zur Drehachse 5, sondern in einem Winkel α hierzu verläuft.

Dreht sich nun das zylindrische Target 1 b, so beginnt die Nut 8 von einem Ende des Targets 1 b an in das Plasma einzutauchen und läuft dann in dem Plasma zum anderen Ende des Targets 1 b. Hierdurch wird die Veränderung der Plasmaimpedanz klein gehalten.

In Fig. 3 ist ein weiteres Rohrtarget 9 dargestellt, dessen zylindrisches Target 1 c zwei Nuten 10, 11 aufweist, wobei die eine Nut 10 parallel zur Drehachse 5 und die andere in einem Winkel □ hierzu verläuft.

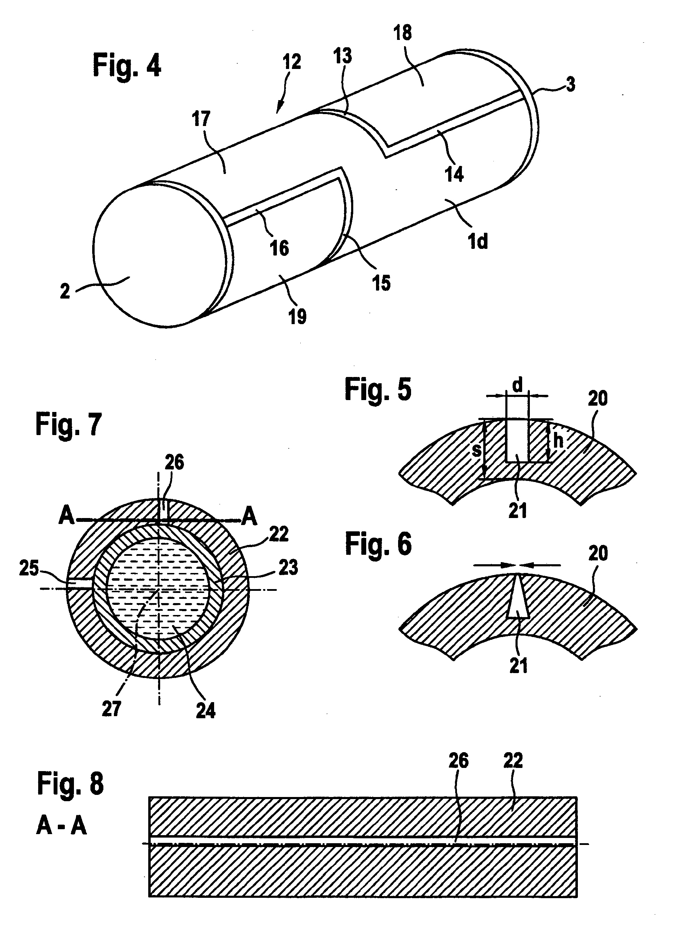

Fig. 4 zeigt ein weiteres Rohrtarget 12, dessen Target 1 d durch Nuten 13 bis 16 in mehrere Segmente 17, 18, 19 unterteilt ist. Die Nuten 13, 15 verlaufen hierbei senkrecht zu den Nuten 14, 16.

In Fig. 5 ist ein Teil eines Targets 20 im Querschnitt gezeigt. Man erkennt hierbei eine Nut 21 mit der Breite d und der Tiefe h. Die Tiefe h ist hierbei kleiner als die Stärke s des Targets 20.

Fig. 6 zeigt den gleichen Abschnitt des Targets 20 wie Fig. 5, jedoch nach Einwirkung einer hohen Plasma-Hitze. Die ursprünglich konstante Nut 21 ist hierbei aufgrund der Ausdehnung des Targets 20 in Richtung auf die äußere Oberfläche des Targets 20 verengt.

Die Fig. 7 zeigt ein Target 22, das auf einem Trägerrohr 23 aufgebracht ist. Innerhalb des Trägerrohrs 23 ist ein Kühlmittel 24 zu erkennen. Die beiden Nuten 25, 26 gehen hierbei durch das ganze Target 22 bis zur Oberfläche des Trägerrohrs 23, und sie verlaufen in der gleichen Richtung wie die Drehachse 27.

Die Anordnung des auf dem Trägerrohr 23 angebrachten Targets 22 ist in Fig. 7 vereinfacht dargestellt. So ist beispielsweise die Bondierung weggelassen.

In der Fig. 8 ist das zylindrische Target 22 der Fig. 7 um 90° gedreht und in einem Schnitt A-A dargestellt. Man erkennt hier wieder die Nut 26.

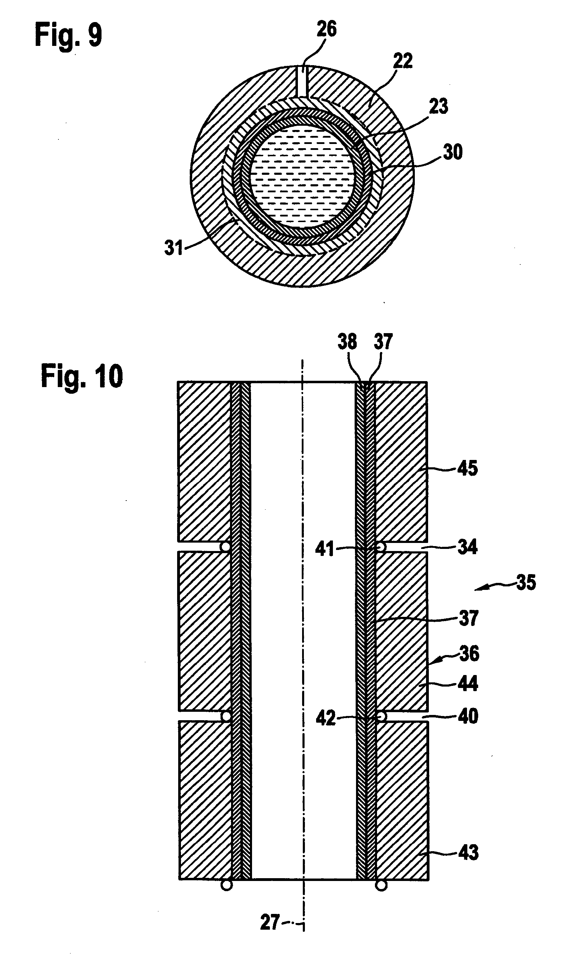

Fig. 9 zeigt eine ähnliche Vorrichtung wie Fig. 7, jedoch mit einem Bondmittel 30, z. B. Indium-Zinn als Lot. Dieses Bondmittel 30 ist zwischen dem Trägerrohr 23, das vorzugsweise aus Kupfer besteht, und dem zylindrischen Target 22 angeordnet. Mit 31 ist ein ungeschlitzter Bereich des Targets 22 bezeichnet. Der Teil des Targets 22, der zu sputtern ist, ist somit nicht gebondet. Die Nut 26 ist hierbei nur bis zum Bereich 31 des Targets 22 geführt. Hierdurch kann die Sputterschicht nicht mit Bondmittel 30 kontaminiert werden.

In der Fig. 10 ist eine Variante eines segmentierten Rohrtargets 35 mit segmentiertem Target 36 dargestellt. Diese Target 36 liegt auf einer Bondschicht 37 auf, die ihrerseits ein Trägerrohr 38 umgibt. In den Nuten 34, 40 sind Dichtungsringe 41, 42 vorgesehen. Diese Dichtungsringe 41, 42 werden nur während der Montage des Rohrtargets 35 auf das Trägerrohr 38 benötigt. Bei dieser Montage werden die Segmente 43 bis 45 mit den Dichtungsringen 41, 42 über das Trägerrohr 38 geschoben. Hierauf wird in den Zwischenraum zwischen Trägerrohr 38 und Target 36 ein flüssiges Bondmittel 37 gegossen, das später aushärtet. Während des Eingießens des Bondmittels 37 dienen die Dichtungsringe 41, 42 dazu, das Herauslaufen des Bondmittels 37 aus den Nuten 34, 40 zu verhindern. Nachdem das Bondmittel 37 ausgehärtet ist, werden die Dichtungsringe 41, 42 vorzugsweise entfernt.

Das Trägerrohr 38 verläuft an allen Stellen konzentrisch zum Target 36. Um dies zu erreichen, werden bei der Montage Drähte oder punkt- bzw. linienförmige Distanzstücke eingesetzt.

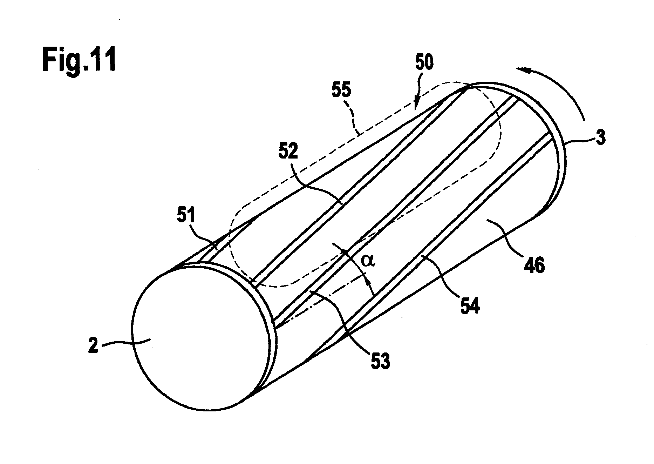

In der Fig. 11 ist ein Rohrtarget 50 mit einem Target 46 dargestellt, das im Prinzip dem Rohrtarget nach Fig. 2 entspricht, aber mehrere schräge Nuten 51 bis 54 aufweist. Über dem Rohrtarget 50 ist eine Plasmazone 55 angedeutet. Durch die Verwendung mehrerer schräger Nuten 51 bis 54 wird die Arcing-Gefahr weiter verringert. Der Winkel α der Nuten 51 bis 54 zur Längsachse des Rohrtargets 50 wird vorzugsweise so gewählt, dass das eine Ende z. B. der Nut 52 in die Plasmazone 55 eintritt, wenn das andere Ende dieser Nut 52 aus der Plasmazone 55 austritt. Entsprechend tritt das eine Ende der nachfolgenden Nut 53 in die Plasmazone 55 ein, wenn das letzte Ende der vorangegangenen Nut 52 aus der Plasmazone 55 austritt. Der Winkel α lässt sich über tanα = b/L ermitteln. Dabei ist b die maximale Breite der Plasmazone 55 und L die Länge des Targets 46. Die Nuten 51 bis 54 haben dabei zueinander jeweils den gleichen Abstand.

Obwohl die Ausführungsbeispiele der Erfindung oben detailliert beschrieben wurden, ist die Erfindung nicht auf diese Ausführungsbeispiele beschränkt. Ein Fachmann versteht, dass die Erfindung verschiedene Varianten mit umfasst, mit denen dasselbe Ergebnis erzielt wird wie mit den hier beschriebenen Ausführungsbeispielen. Es ist deshalb für den Fachmann klar, dass mit den hier beschriebenen Ausführungsbeispielen der Schutzumfang der Ansprüche nicht eingeschränkt wird und dass es weitere Varianten, Modifikationen und Alternativen gibt, die unter den Schutzumfang der Ansprüche fallen.

### Bezugszeichenliste

- 1: Rohrtarget
- 1a: Target
- 1b: Target
- 1c: Target
- 1d: Target
- 2: Deckel
- 3: Deckel
- 4: Nut
- 5: Drehachse
- 6: Pfeil
- 7: Rohrtarget
- 8: Nut
- 9: Rohrtarget
- 10: Nut
- 11: Nut
- 12: Rohrtarget
- 13: Nut
- 14: Nut
- 15: Nut
- 16: Nut
- 17: Segment
- 18: Segment
- 19: Segment
- 20: Target
- 21: Nut
- 22: Target
- 23: Trägerrohr
- 24: Kühlmittel
- 25: Nut
- 26: Nut
- 27: Drehachse
- 30: Bondmittel
- 31: ungeschlitzter Bereich
- 34: Nut
- 35: Rohrtarget
- 36: Target
- 37: Bondschicht / Bondmittel
- 38: Trägerrohr

- 40: Nut
- 41: Dichtungsring
- 42: Dichtungsring
- 43: Segment
- 44: Segment
- 45: Segment
- 46: Target

- 50: Rohrtarget
- 51: Nut
- 52: Nut
- 53: Nut
- 54: Nut
- 55: Plasmazone

## Patentansprüche

1. Rohrtarget mit
1.1 einem zylindrischen Trägerrohr (23, 38),
1.2 ein in mindestens ein Segment (17 - 19, 43 - 45) unterteiltes zylindrisches Target (22, 36, 46), das auf dem Trägerrohr (23, 38) angeordnet ist,
1.3 einer Verbindungsschicht (30, 37), die zwischen dem Target (22, 36, 46) und dem Trägerrohr (23, 38) vorgesehen ist,
**dadurch gekennzeichnet, dass** das Target (22, 36) parallel und/oder schräg zu seiner Drehachse (5, 27) wenigstens eine Nut (4, 8, 10, 11, 13, 14, 15, 16, 21, 25, 26, 34, 40, 51 - 54) aufweist.

2. Rohrtarget nach Anspruch 1, **dadurch gekennzeichnet, dass** die Tiefe (h) der wenigstens einen Nut (4, 10, 11, 13, 14, 15, 16, 21, 25, 26, 34, 40, 51 - 54) von der Oberseite zur Innenseite verläuft und mehr als 5 % der Stärke (s) des Targets (22, 36, 46) beträgt.

3. Rohrtarget nach Anspruch 1, **dadurch gekennzeichnet, dass** die wenigstens eine Nut (4, 10, 25, 26) parallel zur Drehachse (5, 27) des Rohrtargets (1, 9) verläuft.

4. Rohrtarget nach Anspruch 1, **dadurch gekennzeichnet, dass** das Target mehrere Nuten (25, 26) aufweist, die parallel zur Drehachse (27) des Rohrtargets verlaufen.

5. Rohrtarget nach Anspruch 1, **dadurch gekennzeichnet, dass** das Target (1 b, 1 c, 46) wenigstens eine Nut (8, 11, 51 - 54) aufweist, die in einem Winkel α zur Drehachse (5) des Rohrtargets (7, 9, 50) verläuft.

6. Rohrtarget nach Anspruch 1, **dadurch gekennzeichnet, dass** das Target (1 c) mehrere Nuten (10, 11) aufweist, von denen wenigstens eine parallel und wenigstens eine in einem Winkel α zur Drehachse (5) des Rohrtargets (9) verläuft.

7. Rohrtarget nach Anspruch 1, **dadurch gekennzeichnet, dass** mehrere Nuten (51-54) in einem Winkel α zur Drehachse des Rohrtargets (50) verlaufen.

8. Rohrtarget nach Anspruch 7, **dadurch gekennzeichnet, dass** die Nuten (51 - 54) jeweils den gleichen Abstand zueinander haben.

9. Rohrtarget nach Anspruch 1, **dadurch gekennzeichnet, dass** das Target (1 a, 1 b, 1c) in Längsrichtung in mindestens ein Segment unterteilt ist.

10. Rohrtarget nach Anspruch 8, **dadurch gekennzeichnet, dass** der Abstand der Nuten (51 - 54) zueinander mindestens der Breite der Plasmazone (55) entspricht.

## Claims

1. Tubular target having
1.1 a cylindrical support tube (23, 38),
1.2 a cylindrical target (22, 36, 46) subdivided into at least one segment (17 - 19, 43 - 45), said target being mounted on the support tube (23, 38),
1.3 a connecting layer (30, 37) which is provided between the target (22, 36, 46) and the support tube (23, 38),
**characterised in that** the target (22, 36) comprises at least one groove (4, 8, 10, 11, 13, 14, 15, 16, 21, 25, 26, 34, 40, 51 - 54) parallel and/or diagonal to its rotation axis (5, 27).

2. Tubular target according to claim 1, **characterised in that** the depth (h) of the at least one groove (4, 10, 11, 13, 14, 15, 16, 21, 25, 26, 34, 40, 51 - 54) extends from the top to the inside and amounts to more than 5% of the thickness (s) of the target (22, 36, 46).

3. Tubular target according to claim 1, **characterised in that** the at least one groove (4, 10, 25, 26) extends parallel to the rotation axis (5, 27) of the tubular target (1, 9).

4. Tubular target according to claim 1, **characterised in that** the target comprises a plurality of grooves (25, 26) which extend parallel to the rotation axis (27) of the tubular target.

5. Tubular target according to claim 1, **characterised in that** the target (1 b, 1 c, 46) comprises at least one groove (8, 11, 51 - 54) which extends at an angle α to the rotation axis (5) of the tubular target (7, 9, 50).

6. Tubular target according to claim 1, **characterised in that** the target (1c) comprises a plurality of grooves (10, 11), of which at least one extends parallel and at least one extends at an angle α to the rotation axis (5) of the tubular target (9).

7. Tubular target according to claim 1, **characterised in that** a plurality of grooves (51 - 54) extend at an angle α to the rotation axis of the tubular target (50).

8. Tubular target according to claim 7, **characterised in that** the grooves (51 - 54) are at the same spacing from one another.

9. Tubular target according to claim 1, **characterised in that** the target (1 a, 1 b, 1 c) is subdivided into at least one segment in the longitudinal direction.

10. Tubular target according to claim 8, **characterised in that** the spacing of the grooves (51 - 54) from one another corresponds at least to the width of the plasma zone (55).

## Revendications

1. Cible tubulaire avec
1.1 un tube porteur (23, 38) cylindrique,
1.2 une cible cylindrique (22, 36, 46) qui est divisée en au moins un segment (17 - 19, 43 - 45) et qui est agencée sur le tube porteur (23, 38),
1.3 une couche de liaison (30, 37) qui est prévue entre la cible (22, 36, 46) et le tube porteur (23, 38),
**caractérisée en ce que** la cible (22, 36) comporte au moins une rainure (4, 8, 10, 11, 13, 14, 15, 16, 21, 25, 26, 34, 40, 51 - 54) parallèle et/ou inclinée par rapport à l'axe de rotation (5, 27) de la cible.

2. Cible tubulaire selon la revendication 1, **caractérisée en ce que** la profondeur (h) de l'au moins une rainure (4, 10, 11, 13, 14, 15, 16, 21, 25, 26, 34, 40, 51 - 54) s'étend du côté supérieur au côté intérieur et vaut plus de 5 % de l'épaisseur (s) de la cible (22, 36, 46).

3. Cible tubulaire selon la revendication 1, **caractérisée en ce que** l'au moins une rainure (4, 10, 25, 26) s'étend parallèlement à l'axe de rotation (5, 27) de la cible tubulaire (1, 9).

4. Cible tubulaire selon la revendication 1, **caractérisée en ce que** la cible comporte plusieurs rainures (25, 26) qui s'étendent parallèlement à l'axe de rotation (27) de la cible tubulaire.

5. Cible tubulaire selon la revendication 1, **caractérisée en ce que** la cible (1b, 1c, 46) comporte au moins une rainure (8, 11, 51 - 54) qui s'étend suivant un angle ● par rapport à l'axe de rotation (5) de la cible tubulaire (7, 9, 50).

6. Cible tubulaire selon la revendication 1, **caractérisée en ce que** la cible (1c) comporte plusieurs rainures (10, 11) dont au moins une s'étend parallèlement à l'axe de rotation (5) de la cible tubulaire (9) et au moins une autre s'étend suivant un angle ● par rapport à l'axe de rotation (5) de la cible tubulaire (9).

7. Cible tubulaire selon la revendication 1, **caractérisée en ce que** plusieurs rainures (51 - 54) s'étendent suivant un angle ● par rapport à l'axe de rotation de la cible tubulaire (50).

8. Cible tubulaire selon la revendication 7, **caractérisée en ce que** les rainures (51 - 54) sont à égale distance les unes des autres.

9. Cible tubulaire selon la revendication 1, **caractérisée en ce que** la cible (la, 1b, 1c) est divisée en au moins un segment dans le sens de la longueur.

10. Cible tubulaire selon la revendication 8, **caractérisée en ce que** la distance entre les rainures (51 - 54) correspond au moins à la largeur de la zone de plasma (55).
